Europäisches Patentamt

European Patent Office

Office européen des brevets

(11) Veröffentlichungsnummer: **0 430 873 A2**

# (12) EUROPÄISCHE PATENTANMELDUNG

(21) Anmeldenummer: 90810862.4

(22) Anmeldetag: 09.11.90

(51) Int. Cl.⁵: **C23C 14/32**, C23C 14/06, F16C 33/34

(30) Priorität: 22.11.89 CH 4190/89

(43) Veröffentlichungstag der Anmeldung:
05.06.91 Patentblatt 91/23

(84) Benannte Vertragsstaaten:
CH DE FR GB LI Patentblatt

(71) Anmelder: BALZERS AKTIENGESELLSCHAFT

FL-9496 Balzers(LI)

(72) Erfinder: Schulz, Hans Dr.
Alte Churerstrasse 792
LI-9496 Balzers(LI)
Erfinder: Bergmann, Erich Dr.
Sarganserstrasse 58
CH-8887 Mels(CH)
Erfinder: Ramm, Jürgen Dr.
Unterdorf 72b
CH-7306 Flaesch(CH)

(74) Vertreter: Keller, René, Dr. et al
Patentanwälte Dr. René Keller & Partner
Postfach 12 Marktgasse 31
CH-3000 Bern 7(CH)

(54) **Wälzkörper mit einer reibungs- und verschleissmindernden harten Oberschicht und Verfahren zur Herstellung der Beschichtung.**

(57) Ein beschichteter Wälzkörper (1) mit einer reibungs-und verschleißmindernden, harten Oberschicht (7) ist vom Grundkörper (3) durch eine Trennschicht (9) getrennt. Die Trennschicht (9) besteht aus einem keramischen, elektrisch nicht leitenden Material. Als Material wird bevorzugt ein Oxid, Nitrid oder Oxynitrid des Aluminiums verwendet. Die Trennschicht (9) schützt den Grundkorper (3) des Wälzkörpers aus z. B. einem nicht korrosionsfesten hochkohlenstoffhaltigen Stahl derart, daß im Betrieb auf Öl als Korrosionsschutz verzichtet werden kann.

Während der Beschichtung der Grundkorper (3) mit dem keramischen Material wird eine pulsierende Gleichspannung an die Grundkörper (3) oder deren Halter angelegt. Vorzugsweise wird die Pulshöhe der pulsierenden Gleichspannung von hohen negativen Werten auf kleine negative Werte während des Bedampfens verändert.

Fig.1

## WÄLZKÖRPER MIT EINER REIBUNGS- UND VERSCHLEISSMENDERNDEN HARTEN OBERSCHICHT UND VERFAHREN ZUR HERSTELLUNG DER BESCHICHTUNG.

Die Erfindung betrifft einen Wälzkörper mit einer reibungs- und verschleißmindernden harten Oberschicht gemäß dem Oberbegriff des Patentanspruchs 1 und ein Verfahren zur Beschichtung, gemäß dem Oberbegriff des Patentanspruchs 8.

Wälzkörper müssen im allgemeinen drei typischen Beanspruchungen widerstehen:

1.) mechanische Wechselbeanspruchungen, welche zur Ermüdung der Oberflächenrandzonen führen können;

2.) Reibungs- und Adhäsionsverschleiß aufgrund von Schlupfbewegungen;

3.) Korrosionsangriff durch die Umgebungsatmosphäre.

Je nach Verwendung der Wälzkörper werden diese Beanspruchungen verschieden stark gewichtet. Eine Erhöhung des Wechselbeanspruchungswerts wurde durch die Verwendung stark kohlenstoffhaltiger Legierungen, wie z. B. 100 Cr 6 erreicht. Reibungs- und Adhäsionsverschleiß sowie Korrosion wurden durch die Verwendung spezieller Fette und Öle reduziert.

Es gibt aber eine Reihe von Einsatzmöglichkeiten von Wälzkörpern, bei denen man gerne auf den Einsatz von Öl als Korrosionsschutz verzichten möchte.

Als Korrosionsschutz wurden auch schon galvanische Zwischenschichten z. B. aus Chrom oder Nickel versucht. Es diffundierte jedoch beim Abscheidungsprozeß Wasserstoff in das Grundmaterial ein, was zu dessen Versprödung führte, wodurch die Dauerbelastungsfähigkeit auf unbrauchbare Werte herabgesetzt wurde.

Der Erfindung liegt die Aufgabe zugrunde, eine auch in korrosiver Umgebung haltbare, einfach herstellbare, reibungs- und verschleißmindernde Beschichtung für Wälzkörper, deren Grundkörper aus Stahl, einem nicht korrosionsbeständigen Material, bestehen, zu schaffen.

Die erfindungsgemäße Lösung der Aufgabe ist hinsichtlich des Wälzkörpers durch die im Anspruch 1 und hinsichtlich des Verfahrens zur Herstellung der Beschichtung durch die im Anspruch 8 angegebenen Merkmale gekennzeichnet.

Die Ansprüche 2 bis 7 beschreiben bevorzugte Ausführungsformen des erfindungsgemäßen Wälzkörpers und die Ansprüche 9 bis 12 bevorzugte Ausführungsarten des erfindungsgemäßen Verfahrens.

Im folgenden wird ein Beispiel des erfindungsgemäßen Wälzkörpers und des erfindungsgemäßen Verfahrens zur Be schichtung des Wälzkörpers anhand von zeichnerischen Darstellungen näher erläutert. Es zeigen:

Fig. 1 einen Schnitt durch eine schematische Darstellung einer Beschichtung eines Wälzkörpers,

Fig. 2 einen Schnitt durch eine schematische dargestellte Aufdampfanlage,

Fig. 3 einen Schnitt durch die Aufdampfanlage in **Figur 2** entlang der Linie III - III, wobei aufgrund einer vorhandenen Rotationssymmetrie nur eine Hälfte der Aufdampfanlage dargestellt ist, und

Fig. 4 einen Schnitt durch eine schematische Darstellung einer Beschichtungsvariante eines Wälzkorpers.

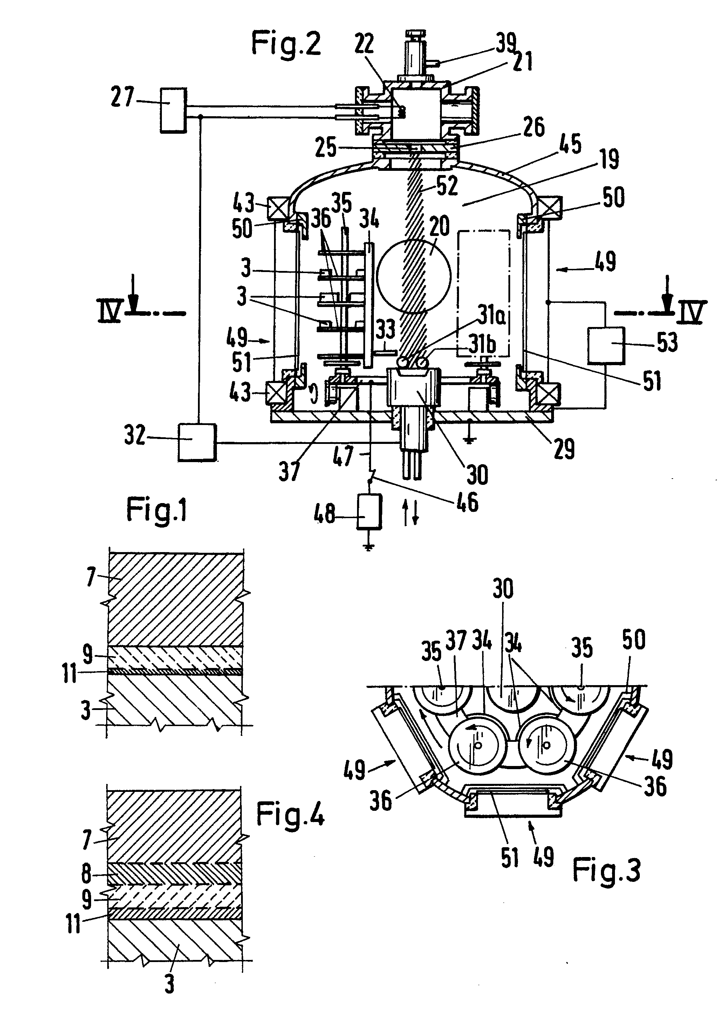

In einem Schnitt senkrecht zur Oberfläche des erfindungsgemäßen Wälzkörpers 1 ist in **Figur 1** dessen Grundkörper **3** mit einer reibungs- und verschleißmindernden, harten Oberschicht **7** an der Außenseite und einer dazwischenliegenden Trennschicht **9** dargestellt. Die nach dem unten beschriebenen Verfahren aufgebrachte Trennschicht **9** ist röntgenamorph, d. h. sie zeigt bei Bestrahlung mit einem Röntgenstrahl auf der der Röntgenquelle abgewandten Seite der Trennschicht **9** nur eine annähernd gaußsche Intensitätsverteilung mit einem Strahlungsmaxima in der Strahlmitte; es ist keine Fernfeldordnung (kein Debye-Scherrer-Diagramm) zu erkennen. Eine röntgenamorphe Beschichtung wird durch eine tiefe Beschichtungstemperatur erreicht. Eine tiefe Beschichtungstemperatur ergibt sich, indem die beim unten beschriebenen Verfahren verwendeten elektrischen Leistungen so niedrig gehalten werden, daß keine Kristallbildung erfolgt.

Die Oberschicht **7** besteht aus Wolfram-Karbid-Kohlenstoff.

Die Trennschicht **9** besteht aus einem keramischen Material, dessen Schichtdicke je nach verwendetem Material und Einsatzgebiet zwischen 0,2 und 3 $\mu$m liegt. Unter einem keramischen Material wird eine chemische Verbindung verstanden, die in ihrer soliden Form als Keramik bekannt ist, wobei der Aufbau der Trennschicht **9** auch amorph sein kann. Als keramische Materialien werden bevorzugt im wesentlichen Aluminiumoxid $Al_2O_3$, wie unten beschrieben, verwendet.

**Figur 2** zeigt eine schematische Darstellung einer beispielsweisen Aufdampfanlage zur Durchführung der erfindungsgemäßen Beschichtung. Die Aufdampfanlage hat eine Vakuumkammer **19** mit einem Evakuierungsanschluß **20** und eine Glühkathodenkammer **21** mit einer Glühkathode **22**, die über eine Öffnung **25** mit der Vakuumkammer **19** verbunden ist. Der die Öffnung **25** beinhaltende Boden **26** der Glühkathodenkammer **21** ist gegenüber den Wänden der Vakuumkammer 19 elektrisch isoliert. Die Glühkathode 22 wird von einem Stromversorgungsgerät 27 gespeist. Unterhalb der Öffnung 25 befindet sich über dem Boden 29 der Vakuumkammer 19 ein Tiegel aus Titan, in dem Aluminium 31a liegt. Der Titantiegel, sog. Titanliner, steht in einem kühlbaren Kupfertiegel. Diese Anordnung wird nachfolgend als Tiegel 30 bezeichnet. Der Titanliner sorgt für eine Wärmeisolation gegenüber dem Kupfertiegel und beeinflußt die Viskosität und die Reaktivität beim späteren Verfahrensablauf gegenüber Sauerstoff günstig. Das Aluminium 31a ist mit einer verschiebbaren Blende 33 abdeckbar. In der Vakuumkammer 19 sind sechs um die Längsachse drehbare, elektrisch leitende Träger 35, von denen vier in **Figur 3** angedeutet sind, vorhanden, an denen die zu beschichtenden Grundkörper 3 aus Stahl an je einer Halterung 36 gehalten werden. Die Träger 35 sind um ihre Achse drehbar auf einem Drehteller 37 angeordnet und durch diesen untereinander elektrisch verbunden. Der Drehteller 37 ist gegenüber dem Boden 29 und den Wänden der Vakuumkammer 19 elektrisch isoliert. Die Halterungen 36 sind mit den Trägern 35 elektrisch leitend verbunden. Die an den Halterungen 36 gehaltenen Grundkörper 3 sind mit einer in **Figur 2** und 3 schematisch dargestellten Blende 34 gegenüber dem Aluminium 31a im Tiegel 30 abdeckbar.

In die Glühkathodenkammer 21 mündet eine Gaszuleitung 39, die über die Öffnung 25 mit der Vakuumkammer 19 verbunden ist. Je eine schematisch dargestellte Magnetspule 43 befindet sich gerade oberhalb des Bodens 29 und am Anschluß eines Deckelteils 45 der Vakuumkammer 19 zur Erzeugung eines annähernd parallelen vertikalen Magnetfelds.

Der Drehteller 37 ist über eine elektrische Leitung 47 und einen geschlossenen Schalter 46 mit einem einstellbaren Spannungsgenerator 48, dessen anderer Pol geerdet ist, verbunden.

In den vertikalen Wänden der Vakuumkammer 19 sind sechs Vorrichtungen 49 zur Kathodenzerstäubung angeordnet, von denen drei in **Figur 3** dargestellt sind. Die Vorrichtung 49 ist mit einem nicht dargestellten Wärmetauscher zur Kühlung versehen. Innerhalb eines Rings 50 liegt ein von ihm isoliertes Target 51 aus Wolframkarbid, welches mit dem negativen Pol einer Spannungsquelle 53 verbunden ist. Der positive Pol der Spannungsquelle 53 ist mit den Wänden der Vakuumkammer 19 und dem Ring 50 verbunden. Die Glühkathode 22 und der Tiegel 30 sind über elektrische Leitungen mit einem Stromversorgungsgerät 32 verbunden.

Zur Herstellung der obigen Beschichtung werden die Grundkörper 3 an den Halterungen 36 der Träger 35 befestigt und Aluminium 31a in den Tiegel 30 gelegt. Anschließend wird die Vakuumkammer 19 geschlossen, auf einen Druck von 2 mPa evakuiert und die zu beschichtenden Oberflächen der Gegenstände 3 entsprechend einem in der DE-OS 34 06 953 bzw. der CH-PS 658 545 beschriebenen Verfahren mit einem Niedervoltbogen 52 auf 450 °C erhitzt und entsprechend einem in der CH-PS 631 743 beschrieben Verfahren gereinigt. Die Blende 33 bedeckt währenddessen das Aluminium 31a im Tiegel 30.

In die Vakuumkammer 19 wird Argon eingeleitet und dessen Druck auf 0,15 Pa eingestellt. Die Blende 33 wird entfernt und der Niedervoltbogen 52 zum Tiegel 30 gezündet. Die Blende 34 vor den Trägern 35 wird weggeklappt und der Strom des Niedervoltbogens 52 wird auf 120 A erhöht, um Aluminium zu verdampfen. Innerhalb der nächsten vier Minuten wird Aluminium ohne Zusatz eines Reaktivgases verdampft und direkt auf der Oberfläche des Grundkörpers 3 als unterster Bereich der Übergangsschicht 11 niedergeschlagen.

Innerhalb der nun folgenden zwei Minuten wird Sauerstoff als Reaktivgas durch die Gaszuleitung 39 mit steigender Zuflußmenge eingelassen und ein Gesamtdruck in der Vakuumkammer 19 von 0,4 Pa eingestellt. Der Sauerstoff wird durch den Niedervoltbogen 52 teilweise ionisiert. Der teilweise ionisierte Sauerstoff und das teilweise ionisierte Aluminium vereinigen sich auf der Oberfläche des Grundkörpers zu $Al_2O_3$ und bleiben auf ihr haften. Je nach der vorhanden Menge Sauerstoff ändert sich das Verhältnis der niedergeschlagenen Menge Aluminiumoxid zu Aluminium. Der Sauerstoffzufluß beträgt bei obigem Enddruck 200 Standardkubikzentimeter pro Minute. Damit die Verdampfungsrate des Aluminiums durch dessen Verbrauch nicht absinkt, wird durch eine nicht dargestellte Stromregelung der Strom des Niedervoltbogens 52 hochgeregelt. Innerhalb der folgenden fünfzehn Minuten ist der Strom des Niedervoltbogens 52 bis auf 200 A hochgeregelt und ein wesentlicher Teil des Aluminiums verdampft. Ist eine Schichtdicke der Trennschicht 9 von 1 $\mu$m aufgebracht, wird der Niedervoltbogen 52 über das Stromversorgungsgerät 32 ausgeschaltet und der Sauerstoffzufluß unterbrochen.

Zur Herstellung der Oberschicht 7 wird der Spannungsgenerator 48 derart eingestellt, daß eine Gleichspannung von dreißig Volt an den Grundkörpern 3 liegt. Durch die Gaszuleitung 39 wird Azetylen als reaktives Gas für eine plasmachemische Reaktion mit einem Gasfluß von etwa 350 Standardkubikzentimeter pro Minute (bei sieben zu beschichtenden Grundkörpern 3) eingelassen; der genaue Gasfluß richtet sich nach der Anzahl der Grundkörper 3 und deren zu beschichtende Flächenausmaße. Der Gasdruck des Azetylens in der Vakuumkammer 19 beträgt etwa 1 Pa.

Die Spannungsquelle 53 wird eingeschaltet und hierdurch der Vorgang des Sputterns vom Target 51 in Gang gesetzt, wobei Wolfram und Wolframkarbid abgestäubt werden. Wolfram und Wolframkarbid sowie Kohlenstoff, welcher aus dem Azetylen durch eine plasmachemische Reaktion herausgelöst wird, schlagen sich auf der Trennschicht 9 als Wolframkarbidkohlenstoff nieder. Ist eine Schichtdicke von 2 μm auf der Trennschicht 9 erreicht, wird die Spannungsquelle 53 ausgeschaltet. Die Vakuumkammer 19 wird geflutet und anschließend zur Entnahme der beschichteten Grundkörper 3 geöffnet.

Die Schichtdicke der Oberschicht 7 wird für allgemein bekannte Anwendung mit einer Dicke, die zwei- bis zehnmal der Schichtdicke der Trennschicht 9 entspricht, vorgenommen.

Es lassen sich neben Wolframkarbidkohlenstoff auch andere Materialien verwenden. Je nach verwendeten Materialien werden neben Sputtern auch andere PVD-Verfahren zum Aufbringen der Oberschicht verwendet.

Die Verwendung anderer Oberschichten ist aus der EP-0 069 701 bzw. aus der Veröffentlichung von Boving, Hintermann, "Properties and performance of chemical vapour deposited TiC-coated ball-bearing components", Thin Solid Films, 153 (1987), 253 - 266 zu entnehmen, wobei hier ohne die erfindungsgemäße Trennschicht 9 gearbeitet wurde und demzufolge auch nicht die große Haftfähigkeit der Beschichtung bei den oben geschilderten Umgebungseinflüssen erreicht wurde.

Bei einigen Oberschichtmaterialien hat es sich als vorteilhaft erwiesen zwischen der Trennschicht 9 und der Oberschicht 7 eine Übergangsschicht 8 aus $Al_xMe_yO_uN_v$, wie in **Figur 4** dargestellt, einzufügen, wobei die Werte für x und u mit wachsender Übergangsschicht 8 ab- sowie die Werte für y und v zur Oberschicht 7 hin zunehmen und Me der Nitridbildner der Oberschicht 7 ist. In dem Fall, in dem TiN als Oberschichtmaterial gewählt wurde, sollten die Werte für u etwa gleich $(3/2) \cdot x$ und die Werte für v etwa gleich den Werten für y sein. Auch hier geht die Trennschicht 9 allmählich in einer Übergangsschicht 11 in Aluminium, dem Bindungspartner des Aluminiumoxids des Materials der Trennschicht 9, zum Grundkörper 3 hin über.

Anstelle nur Aluminium 31a als Oxidbildner in den Titantiegel 30 zu legen, wird zusätzlich Titan 31b hinzugegeben. Der Titanliner sorgt jetzt einerseits für die Wärmeisolation gegenüber dem Kupfertiegel und erleichtert andererseits die Legierbarkeit von Aluminium mit Titan. um die Viskosität und die Reaktivität beim späteren Verfahrensablauf gegenüber Sauerstoff günstig zu beeinflussen. Das Aluminium 31a und das Titan 31b sind vor dem Reinigungsvorgang der Grundkorper 3 mit der Blende 33 abgedeckt.

Nach dem oben beschriebenen Reinigungs- und Aufheizvorgang wird die Blende 33 entfernt und der Niedervoltbogen 52 zum Tiegel 30 gezündet. Bei einem Strom des Niedervoltbogens 52 von 80 A erfolgt ein Legieren von Aluminium 31a und Titan 31b ohne eine wesentliche Verdampfung des Aluminiums. Nach etwas vier Minuten ist dieser Vorgang abgeschlossen, die Blende 34 vor den Trägern 35 wird weggeklappt und der Strom des Niedervoltbogens 52 wird auf 120 A erhöht, um Aluminium zu verdampfen. Aufgrund des hohen Unterschieds von fünf Größenordnungen der Dampfdrücke von Alu minium und Titan wird kein Titan verdampft. Innerhalb der nächsten vier Minuten wird Aluminium ohne Zusatz eines Reaktivgases verdampft und direkt auf der Oberfläche des Grundkörpers 3 als unterster Bereich der Übergangsschicht 11 niedergeschlagen.

Das Aufbringen der Trennschicht 9 aus $Al_2O_3$ erfolgt gemäß dem bereits oben beschrieben Verfahren, wobei innerhalb der folgenden fünfzehn Minuten der Strom des Niedervoltbogens 52 bis auf 200 A hochgeregelt wird und ein wesentlicher Teil des Aluminiums verdampft worden ist. Nun wird die Sauerstoffzufuhr derart stetig reduziert und eine Stickstoffzufuhr derart stetig erhöht, daß obiger Druck von 0,4 Pa in der Vakuumkammer 19 erhalten bleibt. Dieser Verfahrensschritt dauert fünf Minuten und die Übergangsschicht 8 aus $Al_xTi_yO_uN_v$ ist fertig, wobei die Werte für x und u mit wachsender Übergangsschicht 8 ab- und die Werte für y und v zunehmen. Ist eine Schichtdicke der Trennschicht 9 von etwa 1 μm aufgebracht worden.

Während nun folgender dreißig Minuten wird mit dem Niedervoltbogen 52 Titan aus dem Tiegel 30 in der Stickstoffatmosphäre verdampft und auf der Übergangsschicht 8 eine Titannitrid-Hartstoffschicht niedergeschlagen. Danach wird der Niedervoltbogen 52 und die Stickstoffzufuhr abgeschaltet.

Anstelle einer Aluminiumoxidschicht $Al_2O_3$ als Trennschicht 9 kann auch eine Siliziumnitridschicht $Si_3N_4$ aufgebracht werden. Hierbei wird nur Silizium in den Tiegel 30 gegeben. Der Niedervoltbogen 52 wird gezündet und brennt von der Glühkathode 22 zum Silizium im Tiegel 30 mit einer Bogenspannung von 90 V und einem Strom von 60 A, wobei bei Erreichen des Schmelzpunktes die Spannung auf 70 V abfällt und der Strom auf 200 A aufgrund der sich mit der Temperatur erhöhenden Leitfähigkeit des Siliziums ansteigt.

In einem folgenden ersten Verfahrensschritt wird die Stromstärke des Niedervoltbogens 52 auf 200 A bei einer Bogenspannung von 70 V gehalten. Hierdurch wird das Silizium aus dem Tiegel 30 in den gasförmigen Zustand überführt und teilweise ionisiert.

In einem zweiten Verfahrensschritt wird in die beim Reinigungsvorgang verwendete Argonatmosphäre Stickstoff durch die Gaszuleitung **39** eingelassen, der durch den Niedervoltbogen **52** teilweise ionisiert wird. Gleichzeitig wird die Blende **34** vor den Grundkörpern **3** weggeklappt. Der teilweise ionisierte Stickstoff und das teilweise ionisierte Silizium vereinigen sich auf der Oberfläche der Grundkörper **3** zu $Si_3N_4$ und bleiben auf ihr haften. Auch während dieses Verfahrensschritts rotieren die Grundkörper **3**.

Während dieses zweiten Verfahrensschrittes beträgt der Partialdruck des Argons 0,4 Pa und der des Stickstoffs 0,3 Pa. An den Trägern **35** liegt eine pulsierende Gleichspannung mit einer Periodendauer von 10 µs. Zu Beginn dieses Verfahrensschrittes liefert der Spannungsgenerator **48** negative Pulse mit einer Pulsbreite von 8 µs und einer Amplitude von - 200 V. In den folgenden 2 µs sind die Träger **35** über den Spannungsgenerator **48** geerdet. Während dieses Verfahrensschrittes wird die Amplitude derart zu kleineren negativen Werten verändert, daß sie gegen Ende bei - 10 V liegt.

Es kann auch das Material der keramischen Trennschicht **9** mit einem Elektronenstrahl, durch eine Kathodenzerstäubung (Sputtern), eine plasmaunterstütze Verdampfung oder eine kathodische Bogenverdampfung in den gasförmigen Zustand überführt werden.

Es kann auch eine Trennschicht **9** aus einem Oxid und/oder Nitrid eines Oxids eines Elements der Gruppe IVb (Titan, Zirkon, Hafnium), Vb (Vanadium, Niob, Tantal), VIb (Chrom, Molybdän, Wolfram) oder des Chroms oder aus Mischun gen dieser Stoffe oder Mischungen dieser Stoffe mit einem Oxid, Nitrid oder Oxynitrids des Aluminiums erfolgen.

Anstelle den nicht mit der Leitung **47** verbundenen Pol des Spannungsgenerators **48** zu erden, kann er auch an den Tiegel **30** oder an Anodenpotential des Niedervoltbogens **52** angeschlossen werden. Anstelle die Pulshöhe von - 200 V auf - 10 V zu verändern, kann auch die Pulsbreite verkleinert werden; es kann auch die Pulshöhe und die Pulsbreite verändert werden. Es kann auch anstelle einer pulsierenden Gleichspannung eine Wechselspannung verwendet werden; es hat sich jedoch gezeigt, daß die mit pulsierender Gleichspannung erzeugte Beschichtung von besserer Qualität ist.

Die Dicke der Übergangsschicht **11** ist abhängig von der Verwendung des beschichteten Gegenstandes **3**. Zur Vermeidung einer Scherwiderstandsreduktion kann es vorteilhaft sein, die Übergangsschicht **11** ganz wegzulassen.

Bei den erfindungsgemäß beschichteten Grundkörpern **3** erhöht die keramische Trennschicht namentlich die Korrosionbeständigkeit drastisch. Dieses Ergebnis ist namentlich insofern überraschend, als bis jetzt bei mittels PVD aufgebrachten Schichten gewöhnlich "pin holes", die einer Korrosionsbeständigkeit entgegenwirken, beobachtet wurden. Die Erhöhung der Korrosionbeständigkeit ist derart hoch, daß auf den bisherigen Korrosionsschutz der Wälzkörper mit Öl oder Fett verzichtet werden kann. Hierdurch eröffnen sich eine Reihe neuer Verwendungsbereiche.

## Ansprüche

1. Wälzkörper mit einem Grundkörper aus Stahl und einer reibungs- und verschleißmindernden, harten Oberschicht **(7)**, **dadurch gekennzeichnet**, daß die Oberschicht (7) vom Grundkörper **(3)** durch eine Trennschicht **(9)** getrennt ist, die aus keramischem, elektrisch nicht leitendem Material besteht.

2. Wälzkorper **(1)** nach Anspruch 1, **dadurch gekennzeichnet**, daß die Oberschicht eine Härte größer 800 Vickers hat.

3. Wälzkorper **(1)** nach Anspruch 1 oder 2, **dadurch gekennzeichnet**, daß die Trennschicht **(9)** röntgenamorph ist und insbesondere im wesentlichen aus einem Oxid, Nitrid oder Oxinitrid des Aluminiums besteht.

4. Wälzkörper **(1)** nach einem der Ansprüche 1 bis 3, **dadurch gekennzeichnet**, daß die Trennschicht **(9)** eine Schichtdicke von annähernd 0,2 bis 3 µm hat.

5. Wälzkörper **(1)** nach einem der Ansprüche 1 bis 4, **dadurch gekennzeichnet**, daß die Oberschicht **(7)** die zwei- bis zehnfache Dicke der Trennschicht **(9)** hat.

6. Wälzkörper **(1)** nach einem der Ansprüche 1 bis 5, **dadurch gekennzeichnet**, daß die Trennschicht **(9)** unmittelbar auf der Oberfläche des Grundkörpers **(3)** des Wälzkörpers **(1)** und die Oberschicht **(7)** unmittelbar auf der Trennschicht **(9)** liegt.

7. Wälzkörper (1) nach einem der Ansprüche 1 bis 6, **dadurch gekennzeichnet**, daß der Grundkörpers **(3)** des Wälzkörpers wärmebehandelt ist.

8. Verfahren zur Herstellung der Beschichtung mit einem keramischen, elektrisch nicht leitenden Material auf einer Oberfläche eines gegenüber einer Vakuumkammer **(19)** isoliert gehaltenen Grundkörpers **(3)** gemäß einem der Ansprüche 1 bis 7, **dadurch gekennzeichnet**, daß in einem ersten Verfahrensschritt ein Oxid- und/oder Nitridbildner in den gasförmigen Zustand übergeführt und wenigstens teilweise ionisiert wird, in einem zweiten Verfahrensschritt ein Reaktionsgas im wesentlichen Stickstoff und/oder Sauerstoff in die Vakuumkammer **(19)** eingeleitet und wenigstens teilweise ionisiert wird, worauf sich auf der Oberfläche des Grundkörpers **(3)** eine keramische Trennschicht **(9)** aus einer Verbindung des Oxid- bzw. Nitridbildners und des Stickstoffs und/oder des Sauerstoffs niederschlägt, auf die in einem dritten Verfahrensschritt eine harte Oberschicht (7) niedergeschlagen wird.

9. Verfahren nach Anspruch 8, **dadurch gekennzeichnet**, daß, zumindest während des zweiten Verfahrensschritts eine pulsierende Gleichspannung an den Grundkörper (3) und/oder dessen Halter (36) gelegt wird.

10. Verfahren nach Anspruch 9, **dadurch gekennzeichnet**, daß die Pulshöhe der pulsierenden Gleichspannung beginnend mit einem hohen negativen Spannungswert auf einen geringen negativen Wert verändert und zwischen den Pulsen der Grundkörper (3) und/oder dessen Halter (36) geerdet oder auf das Potential des noch nicht in den gasförmigen Zustand überführten Oxid- bzw. Nitridbildners (31) oder auf Anodenpotential einer Bogenentladung (52) zur Überführung des Oxid- bzw. Nitridbildners (31) in den gasförmigen Zustand gelegt wird.

11. Verfahren nach einem der Ansprüche 8 bis 10, **dadurch gekennzeichnet**, daß zur Überführung des Oxid- und/oder Nitridbildners in den gasförmigen Zustand und zu dessen wenigstens teilweiser Ionisierung sowie zur wenigstens teilweisen Ionisierung des Stickstoffs und/oder Sauerstoffs eine Bogenentladung (52) verwendet wird.

12. Verfahren nach einem der Ansprüche 8 bis 11, **dadurch gekennzeichnet**, daß als Oxid- und/oder Nitridbildner für die Trennschicht (9) Aluminium verwendet wird.

Fig.2

Fig.1

Fig.4

Fig.3